Europäisches Patentamt

European Patent Office

Office européen des brevets

(19)

(11) Publication number: **0 280 918**
**A2**

# EUROPEAN PATENT APPLICATION

(12)

(21) Application number: **88101693.5**

(22) Date of filing: **05.02.88**

(51) Int. Cl.⁴: **C23C 18/28**

(30) Priority: **19.02.87 US 16603**

(43) Date of publication of application:
**07.09.88 Bulletin 88/36**

(84) Designated Contracting States:
**DE FR GB**

(71) Applicant: **International Business Machines Corporation**
**Old Orchard Road**
**Armonk, N.Y. 10504(US)**

(72) Inventor: **Mukherjee, Shyama Prasad**
**3101 Cornell Ave.**
**Vestal, N.Y. 13850(US)**
Inventor: **Sambucetti, Carlos Juan**
**4 Sassi Dr.**
**Croton-on-Hudson, N.Y. 10520(US)**
Inventor: **Seraphim, Donald Philip**
**499 Rano Blvd.**
**Vestal, N.Y. 13850(US)**

(74) Representative: **Oechssler, Dietrich, Dr. rer. nat.**
**IBM Deutschland GmbH Patentwesen und Urheberrecht Schönaicher Strasse 220**
**D-7030 Böblingen(DE)**

(54) **Process for metal plating of substrates.**

(57) A process for additively metal plating a substrate wherein the adhesion to said substrate is improved by treating the surface with a sol-gel thin film comprising an alkoxysilane and preferably also comprising a transition metal compound which is then activated to provide catalytic seeds for the plating step. The process is of particular importance for printed circuit boards.

EP 0 280 918 A2

## PROCESS FOR METAL PLATING OF SUBSTRATES

The present application is concerned with a process for metal plating a substrate.

Present day additive plating on substrates such as ceramics, suffers from the limitation of poor adhesion. Such adhesion is particularly poor when the substrate is smooth. Surface smoothness, however, is required in instances where the object is to be used in fine line high density integrated circuits.

The prior art shows the incorporation of salts of catalytic metals in silica gel. This is shown, for example, in U.S. Patents 3,397,153, 4,436,882 and 4,511,744. It is also shown in British Patent Specification 243,123 and UK Patent Application 2,099,715A. These patents, however, are concerned solely with the preparation of catalysts containing silica and are not in any way concerned with the promotion of adhesion to a substrate.

An object of the present invention is to develop a process for plating metal to smooth substrates with the metal having excellent adhesion.

This object is achieved by a process as defined in claim 1.

The sol-gel film is typically applied to the substrate by spin coating it at, for example, 5,000 revolutions per minute, after the substrate has been thoroughly cleaned. When so desired the film can be sintered by heat treatment.

The process of the present invention is typically useful in the manufacture of printed circuit boards which may be made from such substrates.

Because of the presence of the film layer, the adhesion of the plated metal to the substrate is greatly increased.

In one preferred variation of the present invention, the sol-gel film is impregnated with a transition metal compound which is then activated, for example by heat treatment, to provide catalytic seeds for the plating step. The transition metal compound is typically one of the group palladium, copper, nickel, tungsten, molybdenum, platinum, niobium, cobalt or ruthenium, with palladium, copper and nickel being the most preferred. The compound is reduced to the metal, preferably by chemical reduction, for example, with hydrogen. In this way, the metallic nuclei generated in the activation process provide catalytic properties and improved adhesion to the smooth substrate surfaces and the simultaneous deposition of a catalytic film are achieved.

Catalyst precursors containing mixtures of two transition metals are preferred because of their higher catalytic activity. Moreover, since the metallic compound, which is typically hydrated oxide, is first deposited in the gel matrix as finely divided amorphous material and subsequently reduced to amorphous metal, the catalytic activity obtained by the gel rout is higher than that obtained with the process where large size clusters with crystallinity are developed. An appropriate choice of metal compound precursors such as organometallic compounds, acetylacetonate of metals or metal alkyl, will eliminate the need of hydrogen reduction.

The process of the present invention also lends itself to selective seeding by using masks. This feature is of particular importance for printed circuit boards.

Gels useful in the present process include pure silica, copper-silica and palladium-silica. Palladium ions are preferred as seeds in the gels to initiate adhesive copper plating. Palladium (+2) ions may be introduced either during sol preparation or by deep coating the gel in a solution of palladium sulphate. Other palladium compounds such as palladium acetate and palladium acetylacetonate are preferred for the stability in organic solvents but prone to reduction on heating. Similarly, copper acetylacetonate and copper formate are better precursors for subsequent reduction to metallic copper by thermal treatment.

Other advantageous embodiments of the inventive process are disclosed in the subclaims.

The invention will become more apparent from the following detailed description.

The following Examples are given solely for the purpose of illustration and are not to be considered as limitations of the present invention, many variations of which will occur to those skilled in the art without departing from the spirit or scope thereof.

Examples

The following illustrate preferred methods of preparing sol-gels to be used in the process of the present invention:

Example I - Pure Silica Sol Preparation

## Table 1:   Sol Composition

|  | $C_2H_5OH$ | TEOS* | $H_2O$ | $HNO_3$ |
|---|---|---|---|---|
| moles | 15 | 0.8 | 5.8 | -- |
| ml | 75.6 | 15.3 | 9.1 | 5 μml |

*(TEOS is tetraethoxy silane)

Preparation:

1. Mix TEOS with alcohol at room temperature for 10 minutes.
2. Heat to 40 degrees C; add one small drop concentrated $HNO_3$ with water, drop-by-drop.
3. Stir for two hours at 35-40 degrees C.
4. Deposit on substrate by dipping or spinning.
5. Coat the dipped substrate with $PdSO_4$ if desired.

Example II - Copper-Silica Sol Preparation

## Table 2:   Sol Composition

|  | $C_2H_5OH$ | TEOS | $Cu(NO_3)_2 \cdot 3H_2O$ | $HNO_3$ |
|---|---|---|---|---|
| moles | 0.567 | 0.05 | 0.006 | -- |
| ml | 32 | 11.12 | 1.15 g in 8 mls $C_2H_5OH$ | 10-15 μml |

Preparation:

1. Mix alcohol and TEOS at room temperature for 10 minutes.
2. Add 2-3 drops concentrated $HNO_3$ with stirring.
3. Dissolve $Cu(NO_3)_2 \cdot 3H_2O$ in ethanol and add slowly to above solution.

Example III - Palladium-Silica Sol Preparation

Table 3:  Sol Composition

|       | $C_2H_5OH$ | TEOS | $H_2O$ | $PdSO_4$ * |
|-------|--------|------|-----|----------|
| moles | 15     | 0.8  | --  | --       |
| ml    | 75.6   | 15.3 | 6.8 | 2.3      |

*(Solution has 1.04 weight percent $Pd^{+2}$)

Preparation:

1. Mix alcohol and TEOS at room temperature for 10 minutes.
2. Add water and $PdSO_4$ dropwise.
3. Precipitation of Pd metal will occur at various times depending upon the solution $p_H$.

The above formulas were applied to substrates such as glass, alumina and polyimide. The glass and alumina substrates were cleaned ultrasonically in isopropanol and treated at 40 degrees C at an infrared lamp before being treated. The coatings were applied by spinning at 5,000 revolutions per minute. When multiple gel coatings were applied, the substrates were dried under an infrared lamp at 40-60 degrees C for 10-30 minutes.

The coated substrates were plated in a synthetic beaker bath by conventional plating methods. Excellent results were obtained, including particularly improved adhesion.

Example IV - Bimetallic Catalyst Preparation

Copper-silica gel films were applied to the substrate and, subsequently, these wet-gel films were coated with aqueous solutions of palladium sulphate by dipping technique. Subsequently, the gel film impregnated with the $Pd^{+2}$ ions were heated in $N_2$-atmosphere to approximately 350 degrees C and subsequently the gel-coated substrates were plated in an additive bath. The surface containing the catalytic seeds consisting of both copper and palladium showed much higher catalytic activity and higher adhesion than those obtained with one metallic catalyst, e.g. Pd-alone. Thus, the gel technique offers a unique approach to making noncrystalline and extremely small size ($\leq$ 2 nm) and uniformly distributed bimetallic transition metal alloy clusters which can give higher catalytic activity, and higher adhesion. Since $Pd^{+2}$ ions diffuse into the gel layer, a porous layer having a concentration gradient of $Cu^{\circ}Pd^{\circ}$ (metal) is produced. Consequently, the additive metal plating occurs in a gradient, so a gradient interface between substrate and metal film develops. The adhesive strength is much higher with a gradient interface instead of a sharp interface.

## Claims

1. A process for metal plating a substrate, said process comprising the steps of:
   (1) providing a substrate,
   (2) applying to said substrate a liquid sol-gel as a thin film, said sol-gel comprising an alkoxysilane, and
   (3) plating metal, like copper, onto said film.
2. A process as claimed in claim 1, wherein the sol-gel film is impregnated with a transition metal compound which is then activated to provide catalytic seeds for the plating step.

3. A process as claimed in claim 2, wherein the activation is by means of chemical reduction or by means of heat treatment.

4. A process according to claim 2 or 3, wherein the transition metal compound is one of palladium, copper or nickel.

5. A process according to any one of claims 2 to 4, wherein the transition metal compound is an organometallic compound, an acetylacetonate of metals or a metal alkyl.

6. A process according to any one of claims 2 to 5, wherein a compound or compounds of two transition metals is used for impregnating.

7. A process according to any one of claims 2 to 6, wherein the seeding is made selective by using masks.

8. A process according to any one of claims 1 to 7, wherein the thin film is from 0.1 $\mu$m to 1.0 $\mu$m thick.

9. A process according to any one of claims 1 to 8, wherein the substrate is glass, alumina, ceramic or a polymer, like a polyimide.

10. A process according to any one of claims 1 to 9, wherein the applicable gels include pure silica, copper-silica and palladium silica.